# EUROPEAN PATENT SPECIFICATION

(11) **EP 3 923 320 B1**
(45) Date of publication and mention of the grant of the patent: **28.05.2025**
(21) Application number: 20777960.4
(22) Date of filing: 19.03.2020
(51) Int. Cl.: H01L 23/473, H05K 7/06, H05K 7/20, H01L 23/40, H01L 23/373

(54) **COOLING STRUCTURE**
KÜHLSTRUKTUR
STRUCTURE DE REFROIDISSEMENT

(30) Priority: 22.03.2019 JP 2019055696
(43) Date of publication of application: 15.12.2021
(73) Proprietor: Resonac Corporation, Tokyo 105-7325 (JP)
(72) Inventor: SHOUDA, Hiroaki, Tagawa-shi, Fukuoka 825-0005 (JP); YAMASHITA, Takahiro, Tagawa-shi, Fukuoka 825-0005 (JP); FUJISAWA, Kazutake, Tagawa-shi, Fukuoka 825-0005 (JP)
(74) Representative: Hoffmann Eitle
(86) International application number: PCT/JP2020/012487
(87) International publication number: WO 2020/196335

(56) References cited:
- WO-A1-2016/080333
- WO-A1-2016/210148
- DE-T5- 112017 002 572
- JP-A- 2003 003 248
- JP-A- 2012 009 498
- JP-A- 2012 015 240
- JP-A- 2017 161 204
- JP-A- H08 204 068
- US-A- 6 166 937
- US-A1- 2004 174 651

## Description

### Technical Field

The present invention relates to a cooling structure.

### Background Art

A vehicle equipped with a motor, such as a hybrid car or an electric car is equipped with a driving means that drives the motor. The driving means includes electronic components such as a power module including a plurality of power semiconductors such as an insulated gate bipolar transistor (IGBT), and a capacitor, and a bus bar electrically joining these electronic components.

When the motor is driven, a large current may flow through the power semiconductor, the capacitor, and the bus bar joining these electronic components. In this case, the driving means generates heat due to switching loss, resistance loss, or the like, and therefore needs to be cooled efficiently.

As a cooling means for cooling the driving means, a heat sink including a metal such as aluminum or copper is used because of its high thermal conductivity (see, for example, JP 2010 182831 A).

Further examples of previously known cooling structures are derivable from US 6 166 937 A, DE 11 2017 002572 T5, US 2004/174651 A1, as well as JP 2012 009498 A.

### SUMMARY OF INVENTION

### Technical Problem

As in JP 2010 182831 A, in addition to a structure in which a heat sink through which a refrigerant flows is provided immediately below an electronic component such as a power semiconductor or a capacitor to cool the electronic component, a structure is considered in which a bus bar electrically joined to the electronic component provided with the heat sink and receiving heat from the electronic component is provided, and the electronic component is cooled by thermally joining the bus bar and a cooling structure including a cooling fin or the like in contact with the refrigerant.

In the latter structure described above, it is desirable to ensure insulating properties between the bus bar and a flow path configuration member that is made of resin and forms a flow path through which the refrigerant flows.

An aspect of the present invention has been made in view of the above conventional circumstances, and an object of the present invention is to provide a cooling structure having excellent insulating properties between a bus bar and a flow path configuration member.

### Solution to Problem

The object above is solved by means of a cooling structure according to claim 1. Distinct embodiments are derivable from the dependent claims.

### Advantageous Effects of Invention

An aspect of the present invention can provide a cooling structure having excellent insulating properties between a bus bar and a flow path configuration member.

### BRIEF DESCRIPTION OF DRAWINGS

Fig. 1 is a diagram illustrating a cross section of a main part of an embodiment of a cooling structure.
Fig. 2 is a diagram illustrating an example of a region in which cooling fins 24 are provided in a cooling structure 10.
Fig. 3 is a diagram illustrating another example of the region in which the cooling fins 24 are provided in the cooling structure 10.
Fig. 4 is a diagram illustrating a cross section of a main part of a first modification of the cooling structure.
Fig. 5 is a diagram illustrating a cross section of a main part of a second modification of the cooling structure.
Fig. 6 is a view illustrating a cross section of a main part of a third modification of the cooling structure.
Fig. 7 is a diagram illustrating evaluation results of magnetic field shielding performance of a metal layer.
Fig. 8 is a diagram for describing a method of evaluating cooling performance.

### DESCRIPTION OF EMBODIMENTS

### <Cooling Structure>

A cooling structure of the disclosure includes a flow path configuration member made of resin and forming a flow path through which a refrigerant flows, a heat diffuser having a plate shape and embedded in the flow path configuration member or joined to the flow path configuration member, one or more cooling fins extending from the heat diffuser into the flow path, and a bus bar configured to transfer heat to the heat diffuser, in which the flow path configuration member and the bus bar are not in contact with each other with a space interposed between an outer wall surface of the flow path configuration member and the bus bar. The cooling structure of the disclosure has excellent insulating properties between the bus bar and the flow path configuration member.

Hereinafter, the cooling structure of the disclosure will be described with reference to the drawings. Note that sizes of members in the drawings are conceptual, and a relative relationship between the sizes of the members is not limited to the relationship disclosed herein. In addition, members having substantially the same functions are denoted by the same reference signs throughout the drawings, and redundant description may be omitted.

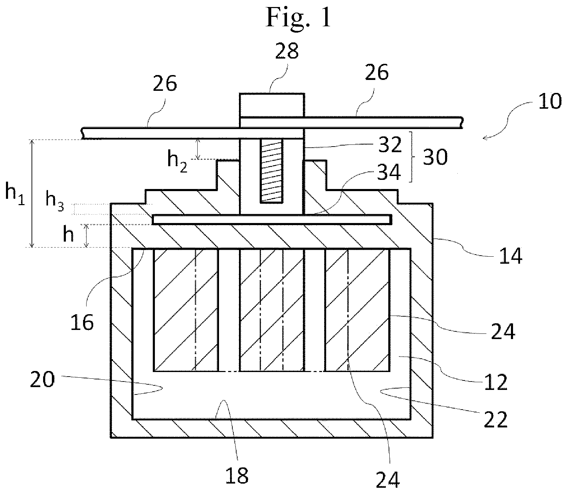

A cooling structure 10 illustrated in Fig. 1 includes a flow path configuration member 14 that is made of resin and forms a flow path 12 through which a refrigerant flows. The flow path may have a substantially rectangular cross section as illustrated in Fig. 1, or may have a circular cross section, an elliptical cross section, a polygonal cross section other than a rectangular cross section, or the like.

The flow path 12 is surrounded by an upper inner wall 16 corresponding to an inner wall of one of a pair of opposing inner walls, a lower inner wall 18 corresponding to an inner wall of the other one of the pair of opposing inner walls, and a side inner wall 20 and a side inner wall 22 that connect the upper inner wall 16 and the lower inner wall 18.

On the upper inner wall 16 side, a plurality of cylindrical cooling fins 24 extends from a heat diffuser 34 having a plate shape to inside of the flow path 12. The heat diffuser 34 is preferably made of metal, and the cooling fins 24 is preferably made of resin similarly to the flow path 12. As a result, since the metal heat diffuser 34 has high thermal conductivity, heat is easily diffused in a plane direction, and the heat diffused in the plane direction is easily dissipated by the cooling fins 24 made of resin and having excellent heat dissipation.

In Fig. 1, a part of each cooling fin 24 is indicated by imaginary lines.

The bus bar 26 cooled by transferring the heat to the heat diffuser 34 is fixed by a bolt 28 and a nut body 32. Specifically, a screw of the bolt 28 is inserted into an opening of the bus bar 26, a part of the bus bar 26 is sandwiched between a head of the bolt 28 and the nut body 32, and thus the bus bar 26 is fixed by the bolt 28 and the nut body 32. The nut 30 includes a nut body 32 and the heat diffuser 34 provided on a side opposite to a side into which the bolt 28 of the nut body 32 is inserted. The heat diffuser 34 has a rectangular plate shape and is integrated with the nut body 32.

The bus bar 26 is connected to electronic components (not illustrated) such as a power semiconductor and a capacitor.

The bus bar 26 is fixed by the bolt 28 and the nut body 32, there is a space between the outer wall surface of the flow path configuration member 14 and the bus bar 26, and the flow path configuration member 14 and the bus bar 26 are not in contact with each other. Thus, a thickness of the flow path configuration member 14 can be reduced as compared with a case in which the outer wall surface and the bus bar 26 are in contact with each other, and a weight of the cooling structure 10 can be reduced.

The entire heat diffuser 34 of the nut 30 and the side of the nut body 32 opposite to the side where the bolt 28 is inserted are embedded in the flow path configuration member 14. The heat diffuser is not limited to be embedded in the flow path configuration member, and may be joined to the flow path configuration member, for example, may be joined to an outer wall of the flow path configuration member without being in contact with the flow path. For example, the heat diffuser may be joined to the flow path configuration member by a resin metal joining technique by laser roughening.

All of the plurality of cooling fins 24 extend from the heat diffuser 34 into the flow path 12. As a result, the heat diffused in a plane direction by the heat diffuser 34 is easily dissipated by the cooling fins 24.

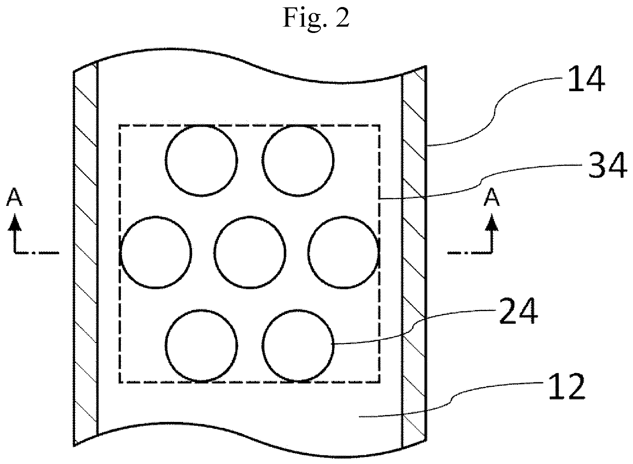

Fig. 2 is a diagram of a region in which the cooling fins 24 is provided in the cooling structure 10 illustrated in Fig. 1, as viewed from an insertion direction of the bolt 28. In order to facilitate understanding of a positional relationship between the cooling fins 24 and the heat diffuser 34, the bus bar 26 and the like are omitted in Fig. 2. In order to facilitate understanding of the positional relationship between the cooling fins 24 and the heat diffuser 34, the heat diffuser 34 is indicated by a dotted line. Fig. 1 is a sectional view taken along line AA illustrated in Fig. 2.

As illustrated in Fig. 2, the number of cooling fins 24 is seven, and the cooling fins 24 are provided in a range where the heat diffuser 34 is disposed. The heat diffuser 34 has a main surface that faces the flow path 12.

Here, when a current flows through the bus bar 26, the bus bar 26 itself generates heat due to a resistance loss. The bus bar 26 is connected to the electronic components (not illustrated), and heat generated from the electronic components by energization is diffused through the bus bar 26. The bus bar 26 is therefore likely to have high temperature.

The heat generated from the bus bar 26 itself and the heat diffused through the bus bar 26 are transferred to a portion integrated with the nut body of the heat diffuser 34 via the bolt 28 and the nut body 32. Since the heat diffuser 34 has a rectangular plate shape, the heat transferred to the heat diffuser 34 is diffused in the plane direction of the heat diffuser 34 and can be diffused in a wide range.

The heat diffuser 34 is disposed at a root of the cooling fins 24, and the heat diffused to the heat diffuser 34 reaches the root of the cooling fins 24 via the flow path configuration member 14. The heat reaching the root of the cooling fins 24 moves from the root of the cooling fins 24 toward the inside of the flow path 12 through the cooling fins 24. At this time, the heat is transferred from the cooling fins 24 to the refrigerant by the refrigerant flowing through the flow path 12. The bus bar 26 and a cooling target such as an electronic component connected to the bus bar 26 are cooled in this way.

In the cooling structure 10, the cooling fins 24 do not reach the lower inner wall 18 from the upper inner wall 16, and distal ends of the cooling fins 24 are located in the flow path 12. The distal ends of the cooling fins 24 may be in contact with the lower inner wall 18 in terms of increasing the amount of refrigerant in contact with the cooling fins 24 to enhance the cooling efficiency of the cooling structure 10. In addition, in a case in which the distal ends of the cooling fins 24 are in contact with the lower inner wall 18, for example, when a load is applied from the upper inner wall 16 toward the lower inner wall 18 (or from the lower inner wall 18 toward the upper inner wall 16), a strength of the cooling structure 10 can be increased.

In Fig. 1, a distance h₁ between the bus bar 26 and an inner wall surface of the flow path configuration member 14 is preferably from 10 mm to 50 mm in terms of the insulating properties and the cooling efficiency.

In a case in which a plurality of the bus bars 26 (two bus bars in the drawing) is fixed by the bolt 28 and the nut body 32 as illustrated in Fig. 1, the distance h₁ means a distance between the bus bar 26 closest to the nut body 32 and a portion of the inner wall surface of the flow path configuration member 14 facing the bus bar 26.

In Fig. 1, a minimum distance h₂ between the bus bar 26 and a portion of the outer wall surface of the flow path configuration member 14 facing the bus bar 26 is preferably 0.2 mm or more, more preferably 0.5 mm or more, and still more preferably 1.0 mm or more in terms of the insulating properties. The minimum distance h₂ is preferably 50 mm or less, more preferably 30 mm or less, and still more preferably 10 mm or less in terms of miniaturization of the cooling structure 10 and the cooling efficiency of the bus bar 26.

In a case in which a plurality of the bus bars 26 (two bus bars in the drawing) is fixed by the bolt 28 and the nut body 32 as illustrated in Fig. 1, the minimum distance h₂ means a minimum distance between the bus bar 26 closest to the nut body 32 and a portion of the outer wall surface of the flow path configuration member 14 facing the bus bar 26.

The heat diffuser may be joined to the outer wall of the flow path configuration member in terms of the heat dissipation. A contact area between the bus bar and the bolt and the nut body is preferably large in terms of the heat dissipation. A shape of the portion of the bolt and the nut body in contact with the bus bar is not limited, and may be circular, elliptical, polygonal, or the like.

In Fig. 1, when the region of the flow path 12 where the cooling fins 24 are provided is observed from upstream in a direction in which the refrigerant flows, an area (area ratio A) of the observed part of the cooling fins 24 in an area of the flow path 12 is preferably 30% or more, more preferably 70% or more, and still more preferably 100%, in terms of improving the cooling efficiency.

In Fig. 1, a minimum distance h from a surface of the heat diffuser 34 on a side of the flow path 12 to the inner wall of the flow path configuration member 14 is preferably 0.3 mm or more in terms of insulating properties, and more preferably 0.5 mm or more and still more preferably 1.5 mm or more in terms of moldability. The minimum distance h is preferably 2.5 mm or less in terms of the cooling efficiency.

In Fig. 1, a minimum distance h₃ from a surface of the heat diffuser 34 on a side of the bus bar 26 to the outer wall of the flow path configuration member 14 is preferably 0.5 mm or more, more preferably 1.5 mm or more in terms of moldability, and is preferably 2.5 mm or less in terms of improving the cooling efficiency. The minimum distance h₃ of 0 mm means that at least a part of the surface of the heat diffuser 34 on the side of the bus bar 26 is not covered with the flow path configuration member 14.

In Fig. 2, a ratio (area ratio B) of a total sectional area of cooling fins 24 extending from the heat diffuser 34 into the flow path 12 in a direction parallel to the main surface of the heat diffuser 34 to an area of the main surface of heat diffuser 34 is preferably 30% or more, and more preferably 70% or more in terms of improving the cooling efficiency. In terms of resistance in the flow path 12, the area ratio B is preferably 70% or less, and more preferably 30% or less.

In Fig. 2, the heat diffuser 34 has a rectangular plate shape, but is not limited to a rectangle, and may be a circle, an ellipse, a polygon other than a rectangle, or the like.

At least a surface of the cooling fins 24 needs to be made of resin, and the entire cooling fins 24 may be made of resin, or the cooling fins may have a metal rod-shaped core material of a surface of which is covered with resin. One end of the core material may be connected to the heat diffuser 34 in terms of improving the cooling efficiency.

In Fig. 1, the distal ends of the cooling fins 24 have a flat shape orthogonal to an extending direction of the cooling fins 24, but a shape of the distal ends of the cooling fins 24 is not limited, and may be hemispherical, conical, pyramidal, or the like.

Examples of the cooling target include electronic components such as a power semiconductor and a capacitor in contact with the bus bar 26. In a case in which the cooling target is an electronic component, the cooling fins may be provided at a portion where the electronic component is disposed in the cooling structure.

The number of cooling fins 24 extending from the heat diffuser 34 into the flow path 12 may be one or two or more.

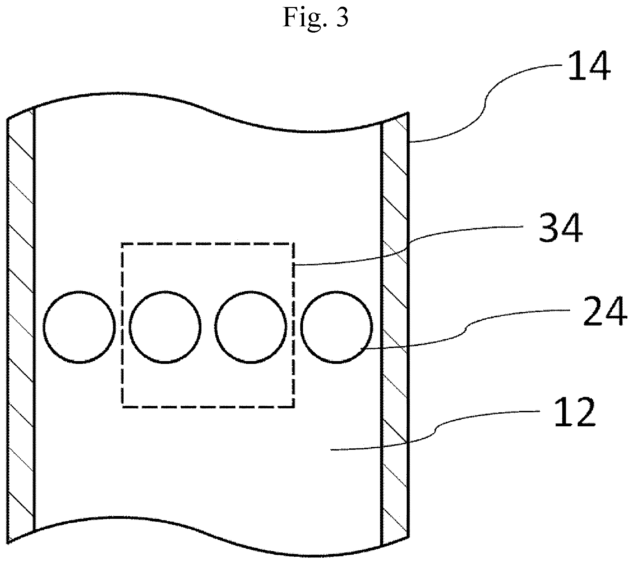

For example, as illustrated in Fig. 3, the cooling fins 24 may be disposed at a position away from the heat diffuser 34.

### (First modification)

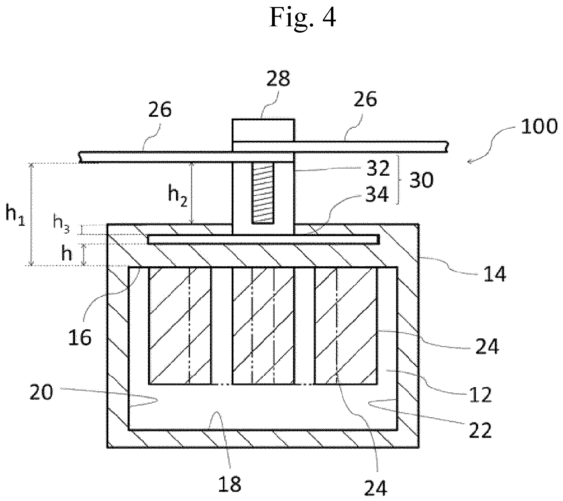

Next, a first modification of the cooling structure 10 according to the embodiment will be described with reference to Fig. 4. A cooling structure 100 according to the first modification is different from the cooling structure 10 in that the distance h₂ between the bus bar 26 and a portion of the outer wall surface of the flow path configuration member 14 facing the bus bar 26 is constant, and a distance h₃ from the surface of the heat diffuser 34 on the side of on the bus bar 26 to the outer wall of the flow path configuration member 14 is constant. A preferable range of the distance h₂ in Fig. 4 is the same as the minimum distance h₂ in Fig. 1.

A preferable range of the distance h₃ in Fig. 4 is preferably more than 0 mm in terms of the insulating properties, more preferably 0.5 mm or more in terms of the moldability, still more preferably 1.5 mm or more, and preferably 2.5 mm or less in terms of the cooling efficiency.

### (Second modification)

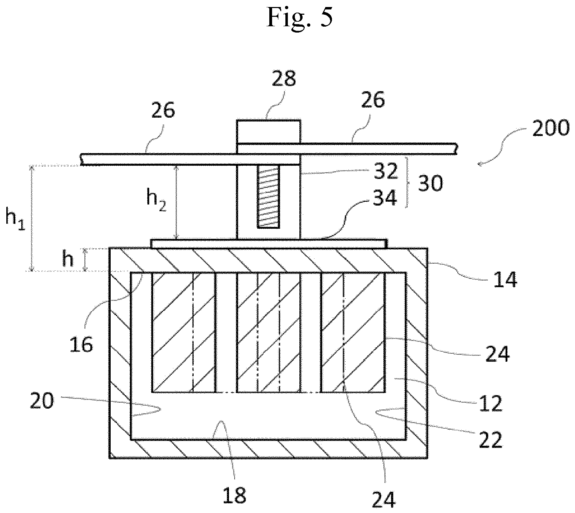

A second modification of the cooling structure 10 according to the embodiment will be described with reference to Fig. 5. A cooling structure 200 according to the second modification is different from the cooling structure 100 in that the distance h₃ from the surface of the heat diffuser 34 on the side of the bus bar 26 to the outer wall of the flow path configuration member 14 is 0 mm, that is, the surface of the heat diffuser 34 on the side of the bus bar 26 is not covered with the flow path configuration member 14.

This cooling structure 200 has excellent cooling efficiency.

### (Third modification)

In a modification of the cooling structure according to the disclosure, a metal layer is provided on at least a part of the outer wall of the flow path configuration member, a power semiconductor, a capacitor, or the like as the cooling target is preferably disposed on the outer wall of the flow path configuration member, and the metal layer is provided such that at least a part of the cooling target is in contact with the metal layer. Since the metal layer is provided such that at least a part of the cooling target is in contact with the metal layer, the heat generated in the cooling target moves to the refrigerant flowing through the flow path via the metal layer, and thus the cooling target can be efficiently cooled.

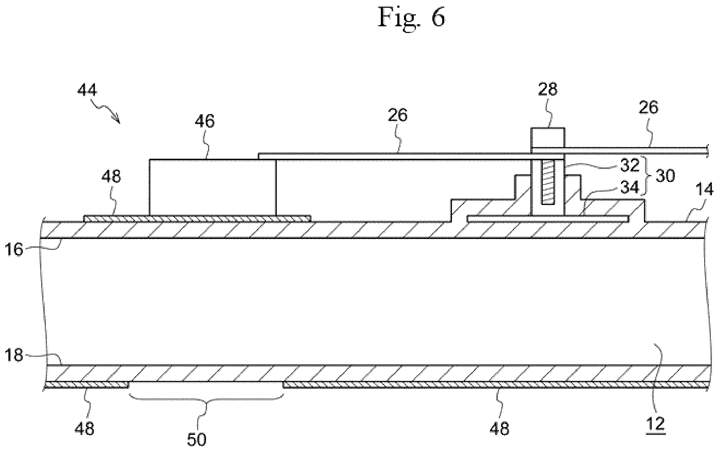

Hereinafter, the modification of the cooling structure according to the disclosure will be described with reference to Fig. 6. Fig. 6 is a sectional view illustrating a main part of the modification of the cooling structure. Fig. 6 illustrates a cross section of a cooling structure 44, parallel to a direction in which the refrigerant flows through the flow path 12. In Fig. 6, the description of the cooling fins is omitted.

In the cooling structure 44 illustrated in Fig. 6, a power semiconductor 46 as a cooling target is in contact with the flow path configuration member 14 with the metal layer 48 provided on the outer wall of the flow path configuration member 14 interposed therebetween. A bus bar 26 is connected to the power semiconductor 46 to ensure conduction with other power semiconductors (not illustrated), other electronic components, and the like. The cooling fins (not illustrated) extend from the upper inner wall 16 toward the lower inner wall 18 at a portion where the flow path configuration member 14 is in contact with the power semiconductor 46. That is, the power semiconductor 46 is disposed at the root of the cooling fins (not illustrated).

Heat generated from the power semiconductor 46 reaches the outer wall of the flow path configuration member 14 via the metal layer 48, and further, the heat reaching the root of the cooling fins (not illustrated) moves from the root of the cooling fins toward the lower inner wall 18 through the cooling fins. At this time, the heat is transferred from the cooling fins to the refrigerant by the refrigerant flowing through the flow path 12. Since the power semiconductor 46 is in contact with the flow path configuration member 14 with the metal layer 48 interposed therebetween, the heat generated from the power semiconductor 46 is likely to efficiently move to the cooling fins, and the cooling efficiency is improved.

In addition, the metal layer 48 can shield a magnetic field in a low frequency range (in particular, a radio band) generated from the power semiconductor 46. It is therefore effective to provide the metal layer 48 on the outer wall of the flow path configuration member 14 in terms of magnetic field shielding. The metal layer 48 only has to be provided on at least a part of the outer wall of the flow path configuration member 14. Note that, the metal layer 48, which is conductive, does not have to be provided at a portion where insulating properties are required. In addition, the metal layer 48 may be formed on the outer wall of the flow path configuration member 14, and the metal layer 48 at the portion where insulating properties are required may be covered with a resin layer.

The metal layer 48 is preferably provided, for example, on the outer wall of the flow path configuration member 14 opposite to a side on which the cooling target is disposed. Further, as shown in Fig. 6, when the metal layer 48 is provided on a part of the outer wall of the flow path configuration member 14 on the side where the cooling target is disposed, a region 50 where the metal layer 48 is not provided may exist on the outer wall of the flow path configuration member 14 opposite to the side on which the cooling target is disposed. Further, a region where the metal layer 48 is not provided may exist on the outer wall opposite to a portion where the heat diffuser 34 in Fig. 6 is disposed.

A method of manufacturing the cooling structure according to the disclosure is not limited, and it is possible to adopt a usual method of molding a resin molded body such as an injection molding method, a die slide injection molding method, a blow molding method, a compression molding method, a transfer molding method, an extrusion molding method, or a cast molding method. Note that the die slide injection molding method is preferable because high positional accuracy may be required for manufacturing the cooling structure 10.

A portion of the nut 30 embedded in the flow path configuration member 14 may be separately manufactured by an insert molding method.

The types of the resins configuring the flow path configuration member 14 and the cooling fin 24 are not limited. Examples of the resin include a polyethylene-based resin, a polypropylene-based resin (PP), a composite polypropylene-based resin (PPC), a polyphenylene sulfide-based resin (PPS), a polyphthalamide-based resin (PPA), a polybutylene terephthalate-based resin (PBT), an epoxy-based resin, a phenol-based resins, polystyrene-based resin, a polyethylene terephthalate-based resin, a polyvinyl alcohol-based resin, a vinyl chloride-based resin, an ionomer-based resin, a polyamide-based resin, an acrylonitrile-butadiene-styrene copolymer resin (ABS), and a polycarbonate-based resin. The resins configuring the flow path configuration member 14 and the resin configuring the cooling fin 24 may be the same or different.

The resins configuring the flow path configuration member 14 and the cooling fin 24 may contain an inorganic filler. Examples of the inorganic filler include silica, alumina, zircon, magnesium oxide, calcium silicate, calcium carbonate, potassium titanate, silicon carbide, silicon nitride, boron nitride, beryllia, and zirconia. Furthermore, examples of the inorganic filler having a flame retardant effect include aluminum hydroxide and zinc borate.

The inorganic fillers included in the resins configuring the flow path configuration member 14 and the cooling fin 24 may be the same or different. One of the resins configuring the flow path configuration member 14 or the resin configuring the cooling fin 24 may include an inorganic filler, and the other does not have to include an inorganic filler.

Examples of the metal configuring the heat diffuser 34 include metals such as aluminum, iron, copper, gold, silver, and stainless steel, and alloys thereof. The bolt 28 and the nut body 32 may also be configured with the above-described metal, and the metal configuring the heat diffuser 34, the bolt 28, and the nut body 32 may be the same or different.

The heat diffuser 34 may have a mesh shape, a punching metal, or the like in terms of suppressing a load on the cooling structure 10 due to a difference in thermal expansion coefficient between the resins configuring the flow path configuration member 14 and the cooling fin 24 and the metal configuring the heat diffuser 34.

In the cooling structure 10, in terms of the heat diffusibility of the heat diffuser 34 in the plane direction and heat dissipation of the cooling fin 24, the metal configuring the heat diffuser 34 is preferably at least one selected from the group consisting of aluminum, iron, copper, gold, silver, and stainless steel, and the resin configuring the cooling fin 24 is preferably at least one selected from the group consisting of a polyphenylene sulfide-based resin, a polyamide-based resin, a polyphthalamide-based resin, a polybutylene terephthalate-based resin, a phenol-based resin, and an epoxy-based resin. Preferable examples of the polyamide resin include nylon 6 and nylon 66.

The type of the refrigerant flowing through the flow path is not limited. Examples of the refrigerant include a liquid such as water and an organic solvent, and a gas such as air. The water used as the refrigerant may include a component such as an antifreeze liquid.

The component configuring the metal layer 48 is not limited, and examples thereof include zinc, aluminum, a zinc-aluminum alloy, carbon steel, stainless steel, nickel, a nickel alloy, tin, copper, a copper alloy, silver, a silver alloy, gold, a gold alloy, and molybdenum. Among these components, silver and copper are preferable in terms of enhancing a magnetic field shielding effect. On the other hand, silver and gold are preferable in terms of the cooling efficiency of the cooling target.

A method of forming the metal layer 48 is not limited, and examples thereof include electrolytic plating, electroless plating, vapor deposition, attachment of a metal plate, and metal spraying. The metal layer 48 is preferably a sprayed metal layer formed by a metal thermal spraying method in terms of formability, and is preferably zinc in terms of workability.

An average thickness of the metal layer 48 is not limited, and is preferably from 1 µm to 2 mm.

An average thickness of the metal layer 48 in contact with the power semiconductor 46 as the cooling target is preferably from 200 µm to 2 mm, and more preferably from 500 µm to 2 mm in terms of the cooling efficiency.

The average thickness of the metal layer 48 provided on the outer wall of the flow path configuration member 14 on the side opposite to the side where the cooling target is disposed is preferably from 1 µm to 2 mm, preferably from 200 µm to 2 mm, and more preferably from 500 µm to 2 mm in terms of magnetic field shielding.

The cooling structure 10 may include a temperature sensor that measures temperature of the refrigerant, and may include a temperature sensor downstream of the region in which the cooling fin 24 extends in the flow path 12. In addition, the amount of the refrigerant may be adjusted in accordance with the temperature of the temperature sensor, or a controller may be provided that adjusts the amount of refrigerant in accordance with the temperature of the temperature sensor.

The cooling structure according to the disclosure is effective for cooling electronic components such as a power module including a plurality of power semiconductors, and a capacitor, and a bus bar electrically joining these electronic components in a vehicle equipped with a motor such as a hybrid vehicle or an electric vehicle.

### Example

Hereinafter, magnetic field shielding performance and cooling performance of the metal layer are studied on the basis of an experimental example.

### Evaluation of Magnetic Field Shielding Performance

A PPS resin plate having a length of 120 mm, a width of 120 mm, and a thickness of 5 mm was prepared and used as a test piece 1.

A zinc layer having an average thickness of 200 µm was formed on one surface of the test piece 1 by a thermal spraying method. This was used as a test piece 2.

An aluminum plate having a length of 120 mm, a width of 120 mm, and a thickness of 500 µm was used as a test piece 3.

For the test piece 1, the test piece 2, and the test piece 3, the magnetic field shielding performance was evaluated by an apparatus for evaluating a magnetic field shielding effect in a KEC method (from 500 Hz to 1 GHz) described below.

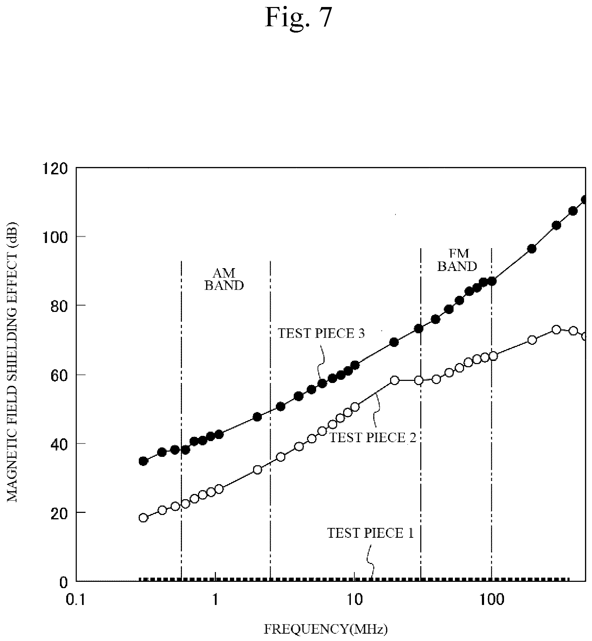

The obtained results are shown in Fig. 7. As is clear from Fig. 7, it can be seen that the test piece 2 and the test piece 3 show a more excellent magnetic field shielding effect than the test piece 1.

### Evaluation of Cooling Performance

A channel model 1 having a rectangular cross section with an outer diameter of 30 mm (width) × 15 mm (length), an inner diameter of 25 mm (width) × 10 mm (length), and a length of 110 mm was formed with use of a PPS resin. A zinc layer 48 having an average thickness of 200 µm was formed on an upper surface of an outer wall of 110 mm × 30 mm of the channel model 1 by the thermal spraying method. This was defined as a channel model 2.

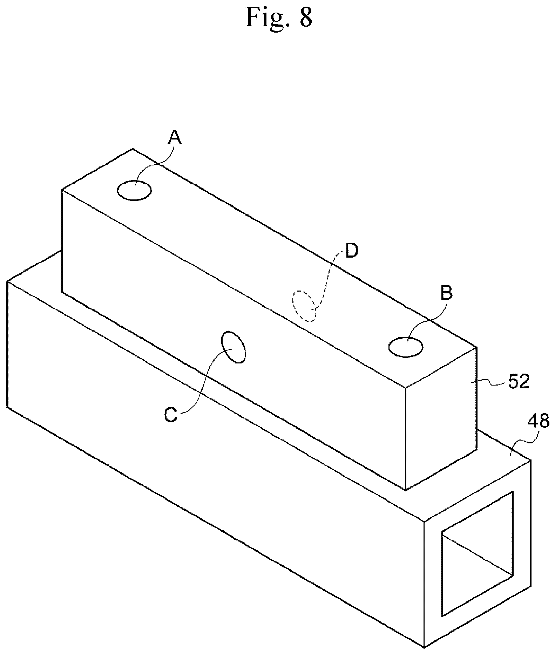

On each of the outer wall of 110 mm × 30 mm of the channel model 1 and the surface on which the zinc layer 48 of the water channel model 2 was formed, an iron block 52 having a size of 95 mm × 25 mm × 15 mm and heated to 100°C was disposed as shown in Fig. 8, and water at 20°C was circulated in each channel model at a flow rate of 8 L/min.

Temperature changes at a total of four points A to D shown in Fig. 8 were measured with a high-performance recorder GR-3500 manufactured by KEYENCE CORPORATION immediately after the iron block 52 was disposed. As a result, the temperature at each measurement point 17 minutes after the iron block 52 was disposed was as shown in Table 1 below, and it became clear that the zinc layer 48 was effective for cooling the cooling target.

**[Table 1]**

| | | Temperature after 10 minutes |
|---|---|---|
| Channel Model 1 | A | 69.2°C |
| | B | 69.3°C |
| | C | 68.7°C |
| | D | 67.4°C |
| Channel Model 2 | A | 38.9°C |
| | B | 40.2°C |
| | C | 39.0°C |
| | D | 38.4°C |

### REFERENCE SIGNS LIST

- 10, 44, 100, 200: Cooling structure
- 12: Flow path
- 14: Flow path configuration member
- 16: Upper inner wall
- 18: Lower inner wall
- 20: Side inner wall
- 22: Side inner wall
- 24: Cooling fin
- 26: Bus bar
- 28: Bolt
- 30: Nut
- 32: Nut body
- 34: Heat diffuser
- 46: Power semiconductor
- 48: Metal layer
- 50: Region
- 52: Iron block

## Claims

1. A cooling structure (10, 44, 100, 200), comprising:
a flow path configuration member (14) made entirely of resin and forming a flow path (12) through which a refrigerant flows;
a heat diffuser (34) having a plate shape and embedded in the flow path configuration member (14) or joined to the flow path configuration member (14);
one or more cooling fins (24) extending from the heat diffuser (34) into the flow path (12); and
a bus bar (26) configured to transfer heat to the heat diffuser (34), wherein:
the flow path configuration member (14) and the bus bar (26) are not in contact with each other with a space interposed between an outer wall surface of the flow path configuration member (14) and the bus bar (26), and
the flow path (12) formed by the flow path configuration member (14) is surrounded by an upper inner wall (16) corresponding to an inner wall of one of a pair of opposing inner walls, a lower inner wall (18) corresponding to an inner wall of the other one of the pair of opposing inner walls, and a side inner wall (20) and a side inner wall (22) that connect the upper inner wall (16) and the lower inner wall (18).

2. The cooling structure (10, 44, 100, 200) according to claim 1, further comprising:
a nut body (32) in contact with the heat diffuser (34); and
a bolt (28) inserted into the nut body (32),
wherein the bus bar (26) is fixed by the nut body (32) and the bolt (28).

3. The cooling structure (10, 44, 100, 200) according to claim 1 or 2, wherein
the heat diffuser (34) includes a metal, and
the cooling fins (24) are made of resin in at least surfaces of the cooling fins (24).

4. The cooling structure (10, 44, 100, 200) according to any one of claims 1 to 3, wherein a minimum distance h₂ between the bus bar (26) and a portion of the outer wall surface of the flow path configuration member (14) facing the bus bar is 0.2 mm or more.

5. The cooling structure (10, 44, 100, 200) according to any one of claims 1 to 4, further comprising a cooling target (46) connected to the bus bar (26).

6. The cooling structure (10, 44, 100, 200) according to any one of claims 1 to 5, wherein an outer wall of the flow path configuration member (14) is at least partially provided with a metal layer (48).

7. The cooling structure (10, 44, 100, 200) according to any one of claims 1 to 4, further comprising a cooling target (46) connected to the bus bar (26), wherein:
the flow path configuration member (14) is provided with a metal layer (48) on at least a part of an outer wall of the flow path configuration member (14), and
the metal layer (48) is in contact with at least a part of the cooling target (46).

8. Method of forming the metal layer (48) of the cooling structure (10, 44, 100, 200) according to claim 6 or 7, comprising the step of forming the metal layer (48) by a metal thermal spraying method.

## Patentansprüche

1. Kühlstruktur (10, 44, 100, 200), umfassend:
ein Strömungspfad-Konfigurationselement (14), das vollständig aus Harz hergestellt ist und einen Strömungspfad (12) bildet, durch den ein Kältemittel strömt;
einen Wärmeverteiler (34), der eine Plattenform aufweist und im Strömungspfad-Konfigurationselement (14) eingebettet oder an das Strömungspfad-Konfigurationselement (14) angefügt ist;
eine oder mehrere Kühlrippen (24), die sich vom Wärmeverteiler (34) in den Strömungspfad (12) erstrecken; und
eine Sammelschiene (26), die dazu konfiguriert ist, Wärme an den Wärmeverteiler (34) zu übertragen, wobei:
das Strömungspfad-Konfigurationselement (14) und die Sammelschiene (26) nicht miteinander in Kontakt sind, mit einem Raum, der zwischen einer Außenwandfläche des Strömungspfad-Konfigurationselements (14) und der Sammelschiene (26) eingefügt ist, und
der durch das Strömungspfad-Konfigurationselement (14) gebildete Strömungspfad (12) umgeben ist von einer oberen Innenwand (16), die einer Innenwand einer von einem Paar gegenüberliegender Innenwände entspricht, einer unteren Innenwand (18), die einer Innenwand der anderen des Paars gegenüberliegender Innenwände entspricht, und einer Seiteninnenwand (20) und einer Seiteninnenwand (22), die die obere Innenwand (16) und die untere Innenwand (18) verbindet.

2. Kühlstruktur (10, 44, 100, 200) nach Anspruch 1, weiter umfassend:
einen Mutterkörper (32) in Kontakt mit dem Wärmeverteiler (34); und
einen Bolzen (28), der in den Mutterkörper (32) eingesetzt ist,
wobei die Sammelschiene (26) durch den Mutterkörper (32) und den Bolzen (28) befestigt ist.

3. Kühlstruktur (10, 44, 100, 200) nach Anspruch 1 oder 2, wobei
der Wärmeverteiler (34) ein Metall einschließt, und
die Kühlrippen (24) zumindest in Oberflächen der Kühlrippen (24) aus Harz hergestellt sind.

4. Kühlstruktur (10, 44, 100, 200) nach einem der Ansprüche 1 bis 3, wobei ein Mindestabstand h₂ zwischen der Sammelschiene (26) und einem Abschnitt der Außenwandfläche des Strömungspfad-Konfigurationselements (14), der der Sammelschiene zugewandt ist, 0,2 mm oder mehr beträgt.

5. Kühlstruktur (10, 44, 100, 200) nach einem der Ansprüche 1 bis 4, weiter umfassend ein Kühlziel (46), das mit der Sammelschiene (26) verbunden ist.

6. Kühlstruktur (10, 44, 100, 200) nach einem der Ansprüche 1 bis 5, wobei eine Außenwand des Strömungspfad-Konfigurationselements (14) zumindest teilweise mit einer Metallschicht (48) bereitgestellt ist.

7. Kühlstruktur (10, 44, 100, 200) nach einem der Ansprüche 1 bis 4, weiter umfassend ein Kühlziel (46), das mit der Sammelschiene (26) verbunden ist, wobei:
das Strömungspfad-Konfigurationselement (14) auf zumindest einem Teil einer Außenwand des Strömungspfad-Konfigurationselements (14) mit einer Metallschicht (48) bereitgestellt ist, und
die Metallschicht (48) mit zumindest einem Teil des Kühlziels (46) in Kontakt ist.

8. Verfahren zum Bilden der Metallschicht (48) der Kühlstruktur (10, 44, 100, 200) nach Anspruch 6 oder 7, umfassend den Schritt des Bildens der Metallschicht (48) durch ein Verfahren des thermischen Spritzens von Metall.

## Revendications

1. Structure de refroidissement (10, 44, 100, 200), comprenant :
un élément de formation de canal d'écoulement (14) fabriqué entièrement en résine et formant un canal d'écoulement (12) à travers lequel un fluide frigorigène s'écoule ;
un diffuseur de chaleur (34) présentant une forme de plaque et intégré dans l'élément de formation de canal d'écoulement (14) ou raccordé à l'élément de formation de canal d'écoulement (14) ;
une ou plusieurs ailettes de refroidissement (24) s'étendant à partir du diffuseur de chaleur (34) dans le canal d'écoulement (12) ; et
une barre omnibus (26) configurée pour transférer de la chaleur au diffuseur de chaleur (34), dans laquelle :
l'élément de formation de canal d'écoulement (14) et la barre omnibus (26) ne sont pas en contact l'un avec l'autre, avec un espace intercalé entre une surface de paroi extérieure de l'élément de formation de canal d'écoulement (14) et la barre omnibus (26), et
le canal d'écoulement (12) formé par l'élément de formation de canal d'écoulement (14) est entouré par une paroi intérieure supérieure (16) correspondant à une paroi intérieure d'une d'une paire de parois intérieures opposées, une paroi intérieure inférieure (18) correspondant à une paroi intérieure de l'autre une de la paire de parois intérieures opposées, et une paroi intérieure latérale (20) et une paroi intérieure latérale (22) qui relient la paroi intérieure supérieure (16) et la paroi intérieure inférieure (18).

2. Structure de refroidissement (10, 44, 100, 200) selon la revendication 1, comprenant en outre :
un corps d'écrou (32) en contact avec le diffuseur de chaleur (34) ; et
un boulon (28) inséré dans le corps d'écrou (32),
dans laquelle la barre omnibus (26) est fixée par le corps d'écrou (32) et le boulon (28).

3. Structure de refroidissement (10, 44, 100, 200) selon la revendication 1 ou 2, dans laquelle
le diffuseur de chaleur (34) inclut un métal, et
les ailettes de refroidissement (24) sont fabriquées en résine dans au moins des surfaces des ailettes de refroidissement (24).

4. Structure de refroidissement (10, 44, 100, 200) selon l'une quelconque des revendications 1 à 3, dans laquelle une distance minimale h₂ entre la barre omnibus (26) et une portion de la surface de paroi extérieure de l'élément de formation de canal d'écoulement (14) faisant face à la barre omnibus est 0,2 mm ou plus.

5. Structure de refroidissement (10, 44, 100, 200) selon l'une quelconque des revendications 1 à 4, comprenant en outre une cible de refroidissement (46) reliée à la barre omnibus (26).

6. Structure de refroidissement (10, 44, 100, 200) selon l'une quelconque des revendications 1 à 5, dans laquelle une paroi extérieure de l'élément de formation de canal d'écoulement (14) est au moins partiellement fournie avec une couche métallique (48).

7. Structure de refroidissement (10, 44, 100, 200) selon l'une quelconque des revendications 1 à 4, comprenant en outre une cible de refroidissement (46) reliée à la barre omnibus (26), dans laquelle :
l'élément de formation de canal d'écoulement (14) est fourni avec une couche métallique (48) sur au moins une partie d'une paroi extérieure de l'élément de formation de canal d'écoulement (14), et
la couche métallique (48) est en contact avec au moins une partie de la cible de refroidissement (46).

8. Procédé de formation de la couche métallique (48) de la structure de refroidissement (10, 44, 100, 200) selon la revendication 6 ou 7, comprenant l'étape de formation de la couche métallique (48) par un procédé de pulvérisation thermique de métal.
